Europäisches Patentamt

European Patent Office

Office européen des brevets

(19)

(11) Publication number: **0 281 182**
**A1**

(12)

# EUROPEAN PATENT APPLICATION

(21) Application number: **88200278.5**

(22) Date of filing: **16.02.88**

(51) Int. Cl.⁴: **G03F 7/26**

(30) Priority: **20.02.87 NL 8700421**

(43) Date of publication of application:
**07.09.88 Bulletin 88/36**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Visser, Robert Jan**
**c/o INT. OCTROOIBUREAU B.V. Prof.**
**Holstlaan 6**
**NL-5656 AA Eindhoven(NL)**
Inventor: **Reuhman Huisken, Maria Elisabeth**
**c/o INT. OCTROOIBUREAU B.V. Prof.**
**Holstlaan 6**
**NL-5656 AA Eindhoven(NL)**
Inventor: **Schellekens, Jacobus Petrus**
**Wilhelmus**
**c/o INT. OCTROOIBUREAU B.V. Prof.**
**Holstlaan 6**
**NL-5656 AA Eindhoven(NL)**
Inventor: **Vollenbroek, Franciscus Antonius**
**c/o INT. OCTROOIBUREAU B.V. Prof.**
**Holstlaan 6**
**NL-5656 AA Eindhoven(NL)**
Inventor: **Juffermans, Casparus Anthonius**
**Henricus**
**c/o INT. OCTROOIBUREAU B.V. Prof.**
**Holstlaan 6**
**NL-5656 AA Eindhoven(NL)**

(74) Representative: **Pennings, Johannes et al**
**Internationaal Octrooibureau B.V. Prof.**
**Holstlaan 6**
**NL-5656 AA Eindhoven(NL)**

(54) Method of manufacturing a semiconductor arrangement.

(57) A method of manufacturing a semiconductor arrangement, in which a layer of a radiationsensitive material is applied to a substrate, which layer is subjected to patterned radiation and subsequently treated with an organosilicon compound, which brings about a silylation reaction to form a desired pattern, after which the layer is developed by means of a plasma, in which method the pattern definition has been improved and the possibility created to work according to a positive process. This can be accredited to an increased selectivity of the silylation reaction thanks to patterned cross-linking of the molecules of the radiationsensitive material, which preceeds the silylation reaction.

FIG.1a

FIG.1b

FIG.1c

FIG.1d

## "Method of manufacturing a semiconductor arrangement."

The invention relates to a method of manufacturing a semiconductor arrangement, in which a layer of a radiationsensitive material is applied to a substrate, which layer is patternwise subjected to radiation and subsequently treated with an organosilicon compound, which brings about a silylation reaction to form a desired pattern, after which the layer is developed by means of a plasma.

Such a method is described in European Patent Application EP 184567 in which a mixture of a novolak and a diazonaphtoquinone compound is described as an example of a radiationsensitive material (resist). The selectivity of the silylation reaction which is carried out with a gaseous organosilicon compound is based on a higher degree of permeability in the irradiated areas. Due to a reaction of the organosilicon compound with phenolic hydroxyl groups silicon-containing organic groups are incorporated in the novolak polymer. When the resistmaterial is developed in a plasma, for example a reactive oxygen containing plasma, a silicon oxide film is formed which protects the underlying layers against etching. Consequently, the pattern irradiated areas are not etched (negative process).

A disadvantage of the known method is that the phenolic hydroxyl groups which are subjected to silylation are present both in the exposed and the non-exposed areas. The degree of selectivity is relatively low because it is only based on a difference in velocity caused by increased permeability in the irradiated areas.

It is an object of the invention to provide a method of manufacturing a semiconductor arrangement of the type as described above having an improved pattern definition (sharp transitions), such that also small details can be accurately etched. A further object of the invention is to provide a method which can suitably be used in a positive process.

This object is achieved according to the invention by a method as described in the opening paragraph, which is further characterized in that the selectivity of the silylation reaction is increased because it is preceded by patterned cross-linking of the molecules of the radiationsensitive material. Due to the cross-linking reaction the incorporation of silicon-containing organic groups is locally strongly suppressed.

The silylation reaction can be carried out by means of hexamethyldisilazane, trimethylsilyldimethylamine, tetrachlorosilane, trimethylchlorosilane or one or more of the organosilicon compounds mentioned for this purpose in European Patent Appliation EP 184567.

United States Patent Specification US 4613398 describes a positive plasma-etching system, in which a resist material is subjected to patterned radiation with shortwave ultraviolet light, thus obtaining a reduction in the permeability of a silylation reagent. The use of shortwave ultraviolet light for patterned exposure, however, has disadvantages of a technological nature and, moreover, cross-linking is obtained only in the surface layer of the resist material.

The method according to the inventio may be used in a negative process, in which a radiationsensitive material is used in which in the presence of water acid groups are formed under the influence of patterned irradiation, after which in the non-exposed areas a cross-linking reaction is carried out under the inflence of a flood exposure excluding water, after which the silylation reaction is carried out.

The expression "in the presence of water" is to be understood to mean herein that small quantities of water are present, for example, because the work is carried out under normal atmospheric conditions (50% relative humidity as is usual in clean rooms in which semiconductor arrangements are manufactured). When water is to be excluded, the work can be carried out, for example, in a vacuum, underneath a protective gas or in dried air.

The method according to the invention may also be employed in a positive process, for which purpose a radiationsensitive material is used in which through patterned irradiation and excluding water a cross-linking reaction is carried out, after which the silylation reaction is carried out. A further improvement of the selectivity is obtained when after the patterned irradiation and before the silylation reaction a complete irradiation of the layer takes place in the presence of water, acid groups being formed in the non exposed patternwise-areas. In a very suitable embodiment of this method according to the invention, the radiationsensitive material comprises novolak and a diazonaphtoquinone compound, and the cross-linking reaction is an esterification reaction. The formation of acid groups in the non-exposed patternwise-areas reduces the physical cross-linking,thereby causing these areas to swell, which leads to an increase of thepermeability to the organosilicon compound.

In an alternative embodiment of a positive process according to the invention, a radiationsensitive material is used in which an acid is formed under the influence of patterned irradiation, after which the temperature is raised such that an acid-catalyzed cross-linking reaction is carried out, after which the silylation reaction is carried out. In a very suitable embodiment of this method according to the invention, the radiationsensitive material comprises polyhydroxystyrene (polyvinylphenol), a melamine compound and a radiationsensitive component, for example a chlorine-containing triazine compound. The acid-catalyzed cross-linking reaction is a very sensitive process and it can be carried out with radiation of any wavelength.

Examples of the method according to the invention will now be explained in more detail with reference to examples of embodiments and a drawing, in which

Figures 1a - d schematically shows a number of steps in a method according to the invention (negative system),

Figure 2a - d schematically shows a number of steps in a method according to the invention (positive system),

Figure 3a - d schematically shows a number of steps in an alternative method according to the invention,

Figure 4 shows the structural formula of the repeating unit of a novolak polymer,

Figure 5 shows the structural formula of a benzophenone compound,

Figure 6 schematically shows the reaction mechanisms of acidification and esterification as they can be used in the method according to the invention,

Figure 7 shows the structural formula of the repeating unit of polyparahydroxystyrene,

Figure 8 shows the structural formula of a melamine compound, and in which

Figure 9 shows the structural formula of a chlorine-containing triazine compound.

## Example 1:

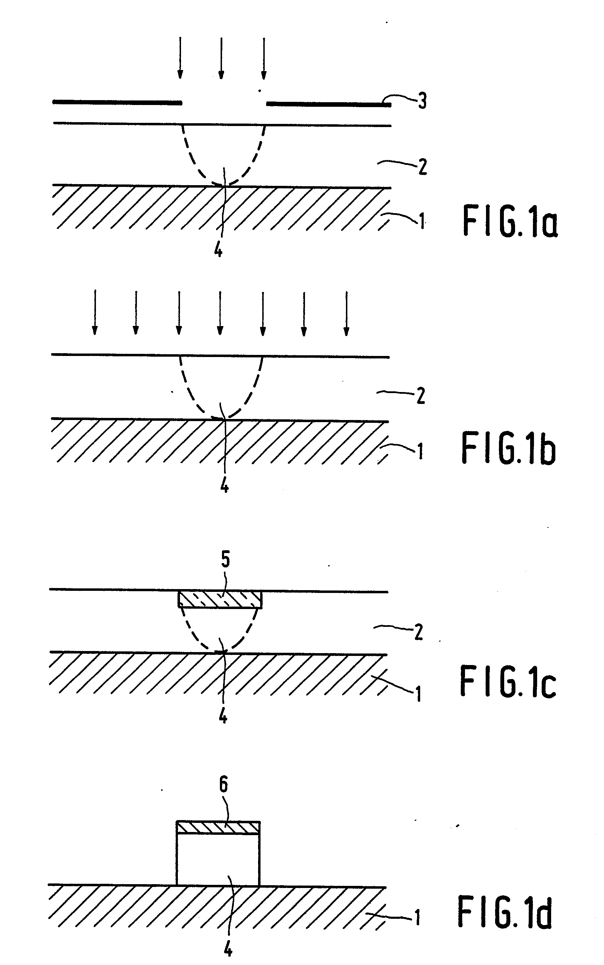

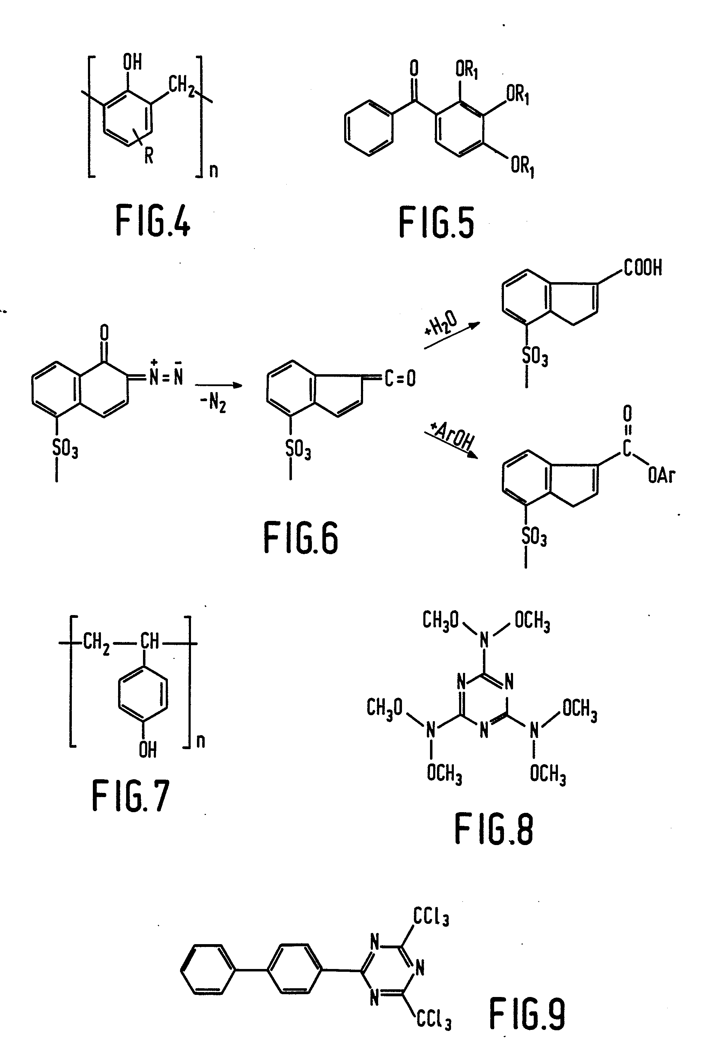

Figure 1a shows a silicon wafer 1 which is coated with a radiationsensitive layer 2 having a thickness of 1.0 $\mu$m by means of spinning. According to this example the resist material used in HPR 204 which is available from Messrs. Hunt. This material contains a novolak polymer, see Figure 4, where according to this example the R group is a methyl grop, and as a radiationsensitive component a triester of a benzophenone compound, see Figure 5, to which three diazoquinone molecules $R_i$ are connected. The group R may be absent from the novolak polymer or may represent another alkyl group. After this material has been provided by means of spinning, the layer is introduced into an air circulation oven and kept at a temperature of 90°C for 30 minutes. The method according to the invention may also be used, for example, in a bilevel system in which the radiationsensitive layer 2 is not directly applied to a silicon substrate but to another polymer layer, for example a planarization layer.

The resist material 2 is irradiated through a contact mask 3 with a high pressure mercury lamp without a filter (total dose approximately 100 mJ/cm$^2$, wavelength 300-500 nm). This irradiation process is carried out under normal atmospheric conditions, i.e. in the presence of water vapour. Instead of UV light electrons or X-rays may be used in the irradiation process. In the exposed area 4 a conversion takes place of the diazoquinone groups, such that nitrogen is separated and indenecarboxylica groups are formed, see Figure 6. Subsequently, the resist material is introduced into a vacuum (0.2 Pa) where it is kept at a temperature of 90°C for 10 minutes.

In a next step, see Figure 1b, the entire layer 2 is irradiated in a vacuum (0.2 Pa) with a high pressure mercury lamp without a filter (dose approximately 450 mJ/cm$^2$, wavelength 300-500 nm) at a temperature of 90°C for 10 minutes. In the non-exposed areas where, hence, there is still radiationsenstive material, esterification takes place between the intermediary ketene groups (formed after the separation of nitrogen) and the phenolic hydroxyl groups of the novolak polymer, see Figure 6. As the triester of the benzophenone compound contains three diazoquinone groups, a network is formed in this process.

Subsequently, a silylation step is carried out, see Figure 1c, by exposing the silicon wafer 1 and the layers it supports to trimethylsilyldimethylamine vapour (9000 Pa) for 50 minutes at a temperature of 100°C. In the areas 5 where no esterification and cross-linking has taken place silicon-containing molecular groups are incorporated in the top layer of the resist material.

Figure 1d shows the result after development with an oxygen plasma in a parallel-plate reactive ion etching device. The silicon-containing material has been converted into a silicon oxide layer 6 which protects the underlaying material against etching (negative image). In plasma etching underetching does not occur.

## Example 2:

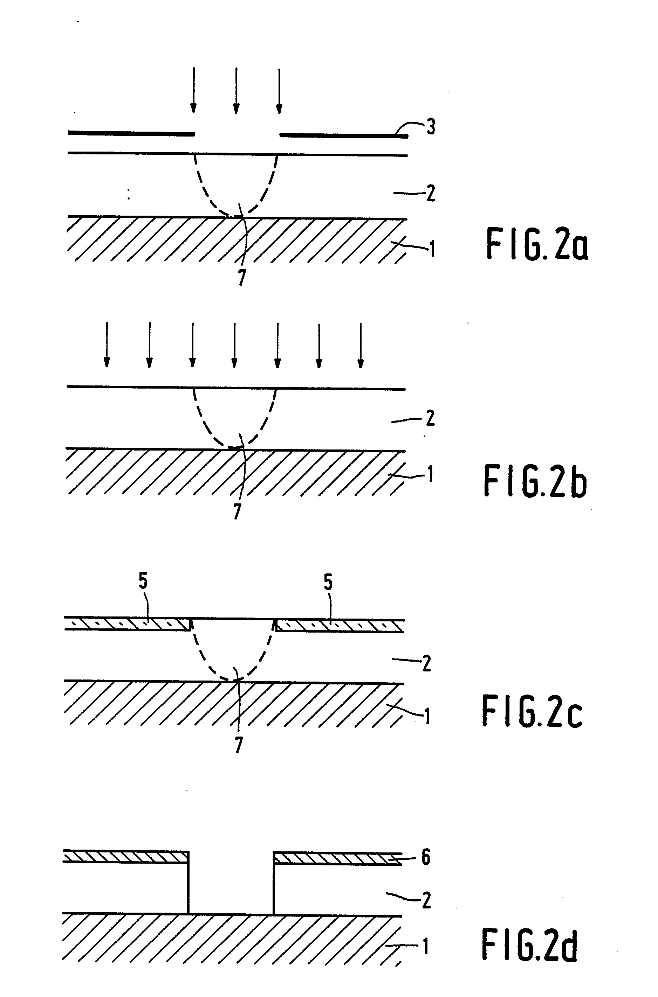

Figures 2a to d show an alternative embodiment of the method according to the invention. The materials used are the same as in example 1. The layer 2 is subjected to patterned radiation through a mask 3, see Figure 1 a (dose approximately 100 mJ/cm$^2$, wavelength 300-500 nm). Unlike example 1, this first patterned exposure is carried out in vacuum (0.2 Pa), i.e. in the absence of water. Instead of acidification, esterification and cross-linking take place in the irradiated area 7, see Figure 6.

In a subsequent complete irradiation of the layer 2 under atmospheric conditions, see Figure 2b, acidification takes place in the non exposed areas. Although this step leads to a better result it is not necessary to obtain the desired result according to the invention.

In a silylation step, see Figure 2c, which is carried out under the same conditions as in example 1, silicon-containing groups are subsequently incorporated in the top layer of the non-exposed patternwise-areas 5.

After development in a reactive oxygen plasma a positive image is formed, see Figure 2d.

Example 3:

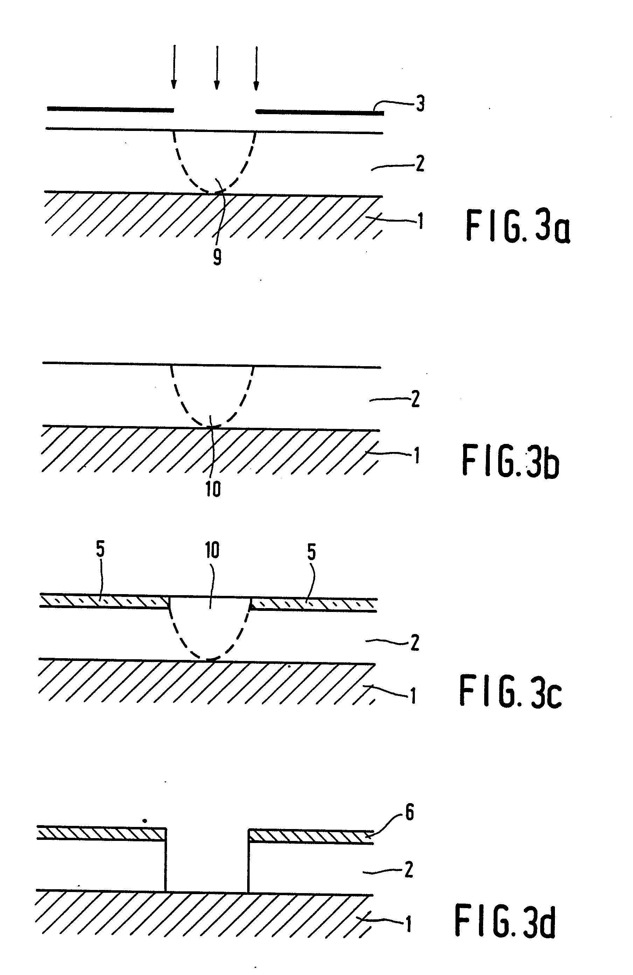

Figure 3a shows a silicon wafer 1 which is provided with a layer 2 of a radiationsensitive material having a thickness of 1.2 $\mu$m. The resist material is prepared from 1.6 g of polyparahydroxystyrene, see Figure 7, having an average molecular weight of 50,000 and containing 0.5 g of a melamine compound, see Figure 8, and 0.5 g of a triazine compound, see Figure 9, in 10 cm³ of AZ diluent (10% toluene, 10% butylacetate and 80% methylglycolacetate). The layer 2 is provided by means of spincoating and is dried at 80°C for 30 minutes.

The layer 2 is subjected to patterned radiation through a mask 3 using UV light (dose approximately 150 mJ/cm², wavelength 300-500 nm). The irradiation process may also be carried out by means of, for example, shortwave or long-wave UV light, electrons or X-rays. In the process an acid is formed in the irradiated areas 9.

Subsequently, the silicon wafer 1 and the layers it supports are kept at a temperature of 80°C for 30 minutes, see Figure 3b, cross-linking taking place in the non-exposed areas 10 under the influence of the acid formed.

The silylation step is carried out in trimethylsilyldimethylamine vapour (9000 Pa) at 80°C for 30 minutes, in which step silicon-containing groups are incorporated in the top layer of the non-exposed areas 5, see Figure 3c.

After development in a reactive oxygen plasma a positive image is formed, see Figure 3d.

Example 4:

The method according to Example 2 is used, in which the first patterned irradiation in vacuum is performed by electron beam lithography, for example with an intensity of 150 mC/cm². In the irradiated areas an esterification of the resist material takes place, which makes the irradiated areas not-reactive in a subsequent silylation reaction. In the non-irradiated areas silicon cotnaining groups are incorporated, forming an etch mask in the top layer. After etching with reactive oxygen ions windows are formed in the resist layer, with straight, essentially perpendicular walls. This is a particular advantage in combination with electron beam lithography (the first, patternwise irradiation step) because it obviates negative effects of the scattering of the electrons.

When on the contrary, a layer is cross-linked by patternwise electron irradiation, after which the non-crosslinked areas are dissolved by a solvent, the walls of the remaining lacquer parts are not straight and show protuberances near the substrate surface. When the liens in the pattern are very narrow or very close this leads to defects in the device (proximity effect). Such problems do not occur in the method according to the invention, where an additional silylation step is incorporated and etching is performed unidirectionally by means of a plasma.

The method according to the invention makes it possible to manufacture semiconductor arrangements having a high resultion and accuracy, such that tracks having a width of 0.4 $\mu$m can be formed in the desired pattern.

**Claims**

1. A method of manufacturing a semiconductor arrangement, in which a layer of a radiationsensitive material is applied to a substrate, which layer is patternwise subjected to radiation and subsequently treated with an organosilicon compound, which brings about a silylation reaction to form a desired pattern, after which the layer is developed by means of a plasma, characterized in that the selectivity of the silylation reaction is increased because it is preceded by patterned cross-linking of the molecules of the radiationsensitive material.

2. A method as claimed in Claim 1, characterized in that a radiationsensitive material is used in which in the presence of water acid groups are formed under the influence of patterned irradiation, after which in the non-exposed areas a cross-linking reaction is carried out under the influence of a flood exposure while excluding water, after which the silylation reaction is carried out.

3. A method as claimed in Claim 1, characterized in that a radiationsensitive material is used in which through patterned irradiation and excluding water a cross-linking reaction is carried out, after which the silylation reaction is carried out.

4. A method as claimed in Claim 3, characterized in that the patterned irradiation is performed in vacuum by electron beam lithography.

5. A method as claimed in Claim 3, characterized in that after the patterned irradiation and before the silylation reaction a complete irradiation of the layer takes place in the presence of water, acid groups being formed in the non-patternwise exposed areas.

6. A method as claimed in any one of the Claims 2 to 5, characterized in that the radiationsenstivie material comprises novolak and a diazonaphtoquinone compound, and in that the cross-linking reaction is an esterification reaction.

7. A method as claimed in Claim 1, characterized in that a radiationsenstivie material is used in which an acid is formed under the influence of patterned irradiation, after which the temperature is raised such that an acid-catalyzed cross-linking reaction is carried out, after which the silylation reaction is carried out.

8. A method as claimed in Claim 7, characterized in that the radiationsensitive material comprises polyhydroxystyrene and a radiationsensitive component.

FIG.1a

FIG.1b

FIG.1c

FIG.1d

FIG.2a

FIG.2b

FIG.2c

FIG.2d

FIG.3a

FIG.3b

FIG.3c

FIG.3d

FIG.4

FIG.5

FIG.6

FIG.7

FIG.8

FIG.9

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X,Y | EP-A-0 204 253 (IBM)<br>* Page 12, lines 24-31; page 16, lines 26-34; page 21, lines 9-36; page 26, lines 27-29; example 1; claims * | 1-8 | G 03 F 7/26 |
| Y | IBM TECHNICAL DISCLOSURE BULLETIN, vol. 20, no. 7, December 1977, page 2808, New York, US; J. PACANSKY: "Exposure procedure for positive photoresists"<br>* Whole article * | 1-8 | |
| Y | IBM TECHNICAL DISCLOSURE BULLETIN, vol. 20, no. 7, December 1977, page 2807, New York, US; J. PACANSKY: "Negative photoresists from polymers containing carboxylic acid side chains"<br>* Whole article * | 1-8 | |
| Y | IBM TECHNICAL DISCLOSURE BULLETIN, vol. 20, no. 7, December 1977, page 2806, New York, US; A.C. OUANO et al.: "Negative resists from positive resists"<br>* Whole article * | 1-8 | TECHNICAL FIELDS SEARCHED (Int. Cl.4)<br><br>G 03 F 7/00 |
| Y | RESEARCH DISCLOSURE, no. 262, February 1986, page 79, disclosure no. 26214, New York, US; "Image reversal of positive photoresist without additives"<br>* Abstract * | 1-8 | |
| A | PATENT ABSTRACTS OF JAPAN, vol. 8, no. 167 (E-258)[1604], 2nd August 1984; & JP-A-59 61 928 (HITACHI SEISAKUSHO K.K.) 09-04-1984<br>---      -/- | 1-8 | |

The present search report has been drawn up for all claims

| Place of search | Date of completion of the search | Examiner |
|---|---|---|
| THE HAGUE | 30-05-1988 | RASSCHAERT A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 161 476 (IBM)<br>* Claims *<br>--- | 1-8 | |
| A | EP-A-0 164 248 (ROHM & HAAS)<br>* Claims *<br>----- | 1-8 | |

TECHNICAL FIELDS SEARCHED (Int. Cl.4)

The present search report has been drawn up for all claims

| Place of search | Date of completion of the search | Examiner |
|---|---|---|
| THE HAGUE | 30-05-1988 | RASSCHAERT A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
................................................................
& : member of the same patent family, corresponding document

EPO FORM 1503 03.82 (P0401)